# EUROPEAN PATENT APPLICATION

(11) **EP 4 447 317 A1**
(43) Date of publication of application: **16.10.2024**
(21) Application number: 21967185.6
(22) Date of filing: 08.12.2021
(51) Int. Cl.: H03H 11/04

(54) **NOISE FILTER**

(71) Applicant: MITSUBISHI ELECTRIC CORPORATION, Chiyoda-ku Tokyo 100-8310 (JP)
(72) Inventor: FURUSHO Yasuaki, Tokyo 100-8310 (JP); KOBAYASHI Ryosuke, Tokyo 100-8310 (JP); TERADA Minami, Tokyo 100-8310 (JP); FUJITA Yuki, Tokyo 100-8310 (JP)
(74) Representative: Meissner Bolte Partnerschaft mbB
(86) International application number: PCT/JP2021/045157
(87) International publication number: WO 2023/105687

(57) **Abstract**

An object is to provide a noise filter that can achieve high reliability. A noise filter (10) includes: a noise detection unit (12) which detects a common mode noise (CN) flowing through an electric path (11); an amplification unit (16) which, on the basis of the common mode noise (CN) detected by the noise detection unit (12), generates a cancellation signal (CS) for canceling out the common mode noise (CN); an injection unit (14) which injects the cancellation signal (CS) into the electric path (11); an abnormality detection unit (17) which detects abnormality of the noise filter (10) on the basis of output voltage or output current of the cancellation signal (CS), and outputs an abnormality detection signal (AS); and a protection circuit (18) which inhibits an abnormal cancellation signal (CS) from being injected into the electric path (11), on the basis of the abnormality detection signal (AS).

## Description

### TECHNICAL FIELD

The present invention relates to a noise filter.

### BACKGROUND ART

There is known a power conversion device that converts input power from a power supply to desired DC power or AC power and supplies the power to a load. Such a power conversion device performs power conversion by opening and closing a plurality of switching elements connected in a bridge form, and a high-frequency noise occurs due to operation of the switching elements. The high-frequency noise passes through a parasitic capacitance, etc., and then a ground potential, resulting in a common mode noise flowing to the power supply or the load. Accordingly, in order to suppress such a common mode noise, it is known that a noise filter is provided on an electric path between the power supply and the power conversion device or on an electric path between the power conversion device and the load.

One of such noise filters is an active noise filter. The active noise filter is configured such that, for example, common mode voltage is detected via a ground capacitor connected to a line path between an AC power supply and a rectifier, cancellation voltage having the same magnitude as the detected common mode voltage and having a polarity opposite thereto is generated by a cancellation voltage source, and the cancellation voltage is superimposed between the AC power supply and a connection point of the ground capacitor on the line path (see, for example, Patent Document 1). Thus, in the technology described in Patent Document 1, the cancellation voltage for canceling out voltage of the common mode noise is injected as a noise cancellation signal into an electric path (line path).

### CITATION LIST

### PATENT DOCUMENT

Patent Document 1: Japanese Laid-Open Patent Publication JP 2010-57268 A

### SUMMARY OF THE INVENTION

### PROBLEM TO BE SOLVED BY THE INVENTION

During operation of the active noise filter, the control characteristic of the active noise filter might change due to an environmental factor, an aging factor, or the like. In the active noise filter described in Patent Document 1, in a case where the control characteristic undergoes such change that has not been originally assumed in designing, loss of a control margin (gain margin and phase margin) or the like occurs, so that a noise cancellation signal injected into the electric path oscillates or a compensation amount in noise cancellation becomes excessive, for example, and thus an abnormal noise cancellation signal might be generated. If such an abnormal noise cancellation signal is injected into the electric path, a common mode noise cannot be cancelled out and in addition, the noise cancellation signal itself can cause a problem.

As a general method, an overcurrent protection circuit may be used to detect abnormality from excessive current and stop the active noise filter. However, in the active noise filter, in a case where an injection unit for the noise cancellation signal is formed by an inductive load such as a common mode transformer, high-frequency large current hardly flows due to an inductive impedance of the common mode transformer, and there is a possibility that abnormality due to a high-frequency component cannot be detected by the active noise filter even though abnormality has actually occurred. In a case where the injection unit is formed by a capacitive load such as a capacitor, there is a possibility that abnormality due to a low-frequency component cannot be detected. The active noise filter that cannot detect abnormality continues injecting the abnormal noise cancellation signal.

As described above, the conventional active noise filter has a problem that reliability is not sufficient against change in the control characteristic.

The present invention has been made to solve the above problem, and an object of the present invention is to provide a noise filter that can achieve high reliability.

### MEANS TO SOLVE THE PROBLEM

A noise filter according to the present invention is provided on an electric path connecting an AC power supply, a load, and a power conversion device which converts AC power outputted from the AC power supply and outputs the converted AC power to the load. The noise filter includes: a noise detection unit which detects a common mode noise flowing through the electric path; a cancellation signal generation unit which, on the basis of the common mode noise detected by the noise detection unit, generates a cancellation signal for canceling out the common mode noise; an injection unit which injects the cancellation signal into the electric path; an abnormality detection unit which detects abnormality of the noise filter on the basis of output voltage or output current of the cancellation signal, and outputs an abnormality detection signal; and protection means which inhibits the cancellation signal that is abnormal from being injected into the electric path, on the basis of the abnormality detection signal.

### EFFECT OF THE INVENTION

The noise filter according to the present invention can achieve high reliability.

### BRIEF DESCRIPTION OF THE DRAWINGS

FIG. 1 is a configuration diagram showing a power conversion system according to Embodiment 1.
FIG. 2 is a configuration diagram showing a power conversion device according to Embodiment 1.
FIG. 3 illustrates a common mode noise occurring in the power conversion system according to Embodiment 1.
FIG. 4 is a configuration diagram showing a noise filter in Embodiment 1.
FIG. 5 is a configuration diagram showing a noise detection unit according to Embodiment 1.
FIG. 6 is a configuration diagram showing an example of an amplification unit according to Embodiment 1.
FIG. 7 is a configuration diagram showing an example of an abnormality detection unit according to Embodiment 1.
FIG. 8 is a configuration diagram showing an example of a feature quantity detection unit according to Embodiment 1.
FIG. 9 is a configuration diagram showing an example of a feature quantity comparison unit according to Embodiment 1.
FIG. 10 is a configuration diagram showing an injection unit according to Embodiment 1.
FIG. 11A is a schematic graph showing control response of a main circuit part of the noise filter in Embodiment 1, and shows the control response in a case of having no filter unit.
FIG. 11B is a schematic graph showing the pass characteristic of a filter unit according to Embodiment 1.
FIG. 11C is a schematic graph showing control response of the main circuit part of the noise filter in Embodiment 1, and shows the control response in a case of having the filter unit.
FIG. 12A is a schematic graph showing control response of the noise filter in Embodiment 1, and shows a gain characteristic.
FIG. 12B is a schematic graph showing control response of the noise filter in Embodiment 1, and shows a phase characteristic.
FIG. 13A is a schematic graph showing control response of the noise filter in Embodiment 1 in a case where the control characteristic has undergone change due to occurrence of abnormality, and shows change in the gain characteristic.
FIG. 13B is a schematic graph showing control response of the noise filter in Embodiment 1 in a case where the control characteristic has undergone change due to occurrence of abnormality, and shows change in the phase characteristic.
FIG. 14 is a schematic graph showing an abnormal output waveform at a cancellation signal output unit according to Embodiment 1.
FIG. 15A is a schematic graph showing the waveform of common mode voltage in a normal case.
FIG. 15B is a schematic graph showing the waveform of common mode current in a normal case.
FIG. 15C is a schematic graph showing the waveform of output voltage of a cancellation signal according to Embodiment 1, in a normal case.
FIG. 15D is a schematic graph showing the waveform of output current of the cancellation signal according to Embodiment 1, in a normal case.
FIG. 16A is a schematic graph showing the waveform of common mode voltage in an abnormal case.
FIG. 16B is a schematic graph showing the waveform of common mode current in an abnormal case.
FIG. 16C is a schematic graph showing the waveform of output voltage of a cancellation signal according to Embodiment 1, in an abnormal case.
FIG. 16D is a schematic graph showing the waveform of output current of the cancellation signal according to Embodiment 1, in an abnormal case.
FIG. 17 is a configuration diagram showing a feature quantity detection unit according to another example of Embodiment 1.
FIG. 18 is a configuration diagram showing a noise filter according to Embodiment 2.
FIG. 19 is a configuration diagram showing a noise filter according to Embodiment 3.
FIG. 20 is a configuration diagram of a feature quantity detection unit according to Embodiment 4.

### DESCRIPTION OF EMBODIMENTS

Hereinafter, a noise filter according to embodiments of the present invention will be described in detail with reference to the drawings. In the drawings, the same reference characters denote the same or corresponding parts.

### Embodiment 1

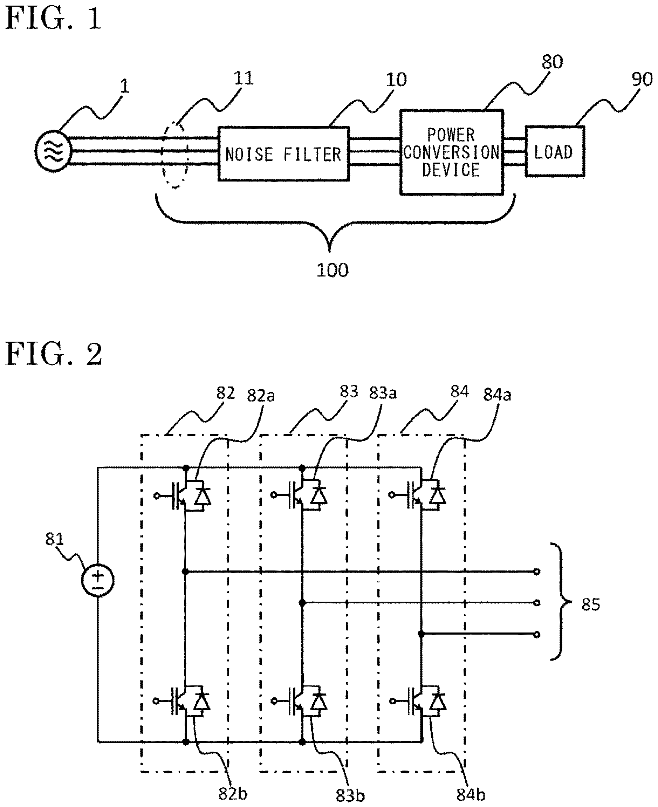

First, Embodiment 1 will be described with reference to FIG. 1 to FIG. 16D.

FIG. 1 is a configuration diagram showing a power conversion system according to Embodiment 1, and FIG. 2 is a configuration diagram showing a power conversion device according to Embodiment 1. A power conversion system 100 includes a power conversion device 80 which is provided between an AC power supply 1 and a load 90 and converts input power from the AC power supply 1 to desired DC power or AC power, and a noise filter 10 interposed between the AC power supply 1 and the power conversion device 80. The AC power supply 1, the noise filter 10, the power conversion device 80, and the load 90 are connected via an electric path 11.

The electric path 11 is connected to a power supply line 2 (not shown) of the AC power supply 1, and input power from the AC power supply 1 is inputted to the power conversion device 80 via the power supply line 2. The power conversion device 80 converts power inputted from the AC power supply 1 to power needed for driving the load 90, and outputs the power. In Embodiment 1, the noise filter 10 is provided between the AC power supply 1 and the power conversion device 80, but may be provided between the power conversion device 80 and the load 90.

As shown in FIG. 2, the power conversion device 80 is a 2-level three-phase inverter. That is, two semiconductor switches 82a, 82b connected in series form one upper-lower arm 82. In addition, two semiconductor switches 83a, 83b connected in series form one upper-lower arm 83. Further, two semiconductor switches 84a, 84b connected in series form one upper-lower arm 84. A DC power supply 81 is connected to the three upper-lower arms 82, 83, 84. The DC power supply 81 is formed by, for example, a converter that converts AC input power inputted from the AC power supply 1 to DC power. Inverter output terminals 85 are connected to middle points of the three upper-lower arms 82, 83, 84. The six semiconductor switches 82a, 82b, 83a, 83b, 84a, 84b perform switching operations, whereby AC power is outputted to the inverter output terminals 85. At this time, the output potential of each inverter output terminal 85 becomes one of the potentials of positive voltage and negative voltage of the DC power supply 81. Therefore, common mode voltage of the power conversion device 80 is constant voltage that is not zero.

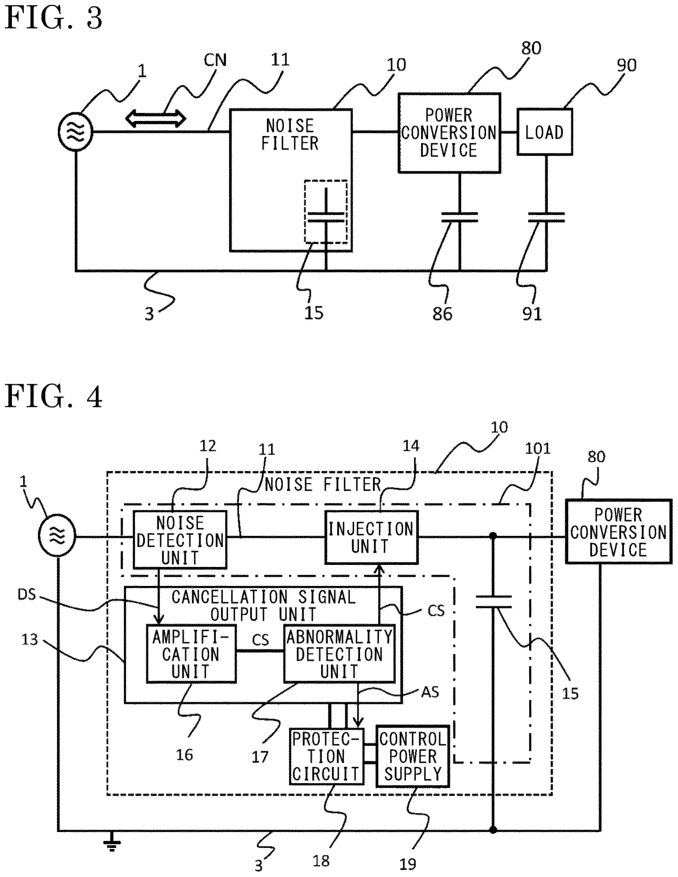

FIG. 3 illustrates a common mode noise occurring in the power conversion system according to Embodiment 1, and shows a common mode equivalent circuit. In the power conversion system 100, the AC power supply 1 and the load 90 are connected on the ground side through a ground line 3, besides the above electric path 11. The noise filter 10 is provided with a ground capacitor 15 whose one end is connected to the ground line 3. In addition, a parasitic capacitance 86 is present between the power conversion device 80 and the ground line 3, and a parasitic capacitance 91 is present between the load 90 and the ground line 3. In the power conversion system 100, common mode voltage of the power conversion device 80 is applied to a common mode loop passing through each parasitic capacitance 86, 91 and the ground line 3, so that common mode current (common mode noise CN) flows as shown by an arrow in FIG. 3.

FIG. 4 is a configuration diagram showing the noise filter in Embodiment 1. The noise filter 10 is interposed between the AC power supply 1 and the power conversion device 80. The noise filter 10 includes: a noise detection unit 12 provided on the electric path 11 connected to the power supply line 2 (not shown); a cancellation signal output unit 13 which generates a cancellation signal CS from the common mode noise CN (not shown in FIG. 4) detected by the noise detection unit 12 and outputs the cancellation signal CS; an injection unit 14 which is provided on the electric path 11 on an output end side, i.e., the power conversion device 80 side, relative to the noise detection unit 12, and injects the cancellation signal CS outputted from the cancellation signal output unit, into the electric path 11; a control power supply 19 which supplies power for generating and injecting the cancellation signal CS, to the cancellation signal output unit 13; and a protection circuit 18 which is interposed between the control power supply 19 and the cancellation signal output unit 13 and can interrupt supply of power from the control power supply 19.

In Embodiment 1, as protection means for inhibiting an abnormal cancellation signal CS from being injected into the electric path 11, power supply interruption means for interrupting supply of power to an amplification unit 16 of the cancellation signal output unit 13 is provided. In Embodiment 1, the protection circuit 18 is provided as one example of the power supply interruption means.

The cancellation signal output unit 13 includes the amplification unit 16 (corresponding to a cancellation signal generation unit) which amplifies a noise detection signal DS outputted from the noise detection unit 12, and an abnormality detection unit 17 which can send an output from the amplification unit 16 as the cancellation signal CS to the injection unit 14 and output an abnormality detection signal AS on the basis of output voltage of the amplification unit 16. In Embodiment 1, the abnormality detection unit 17 is formed by an element and a circuit that have almost no influence on an output characteristic, and the output of the amplification unit 16 becomes substantially the same as the cancellation signal CS. Therefore, unless otherwise specified, the output of the amplification unit 16 is also referred to as the cancellation signal CS.

A filter unit (not shown) that can adjust the characteristic of the cancellation signal CS may be provided between the noise detection unit 12 and the amplification unit 16 or between the amplification unit 16 and the abnormality detection unit 17. In a case where the filter unit is provided between the noise detection unit 12 and the amplification unit 16, the amplification unit 16 amplifies the noise detection signal DS adjusted by the filter unit, to generate the cancellation signal CS.

Also in this case, the characteristic of the cancellation signal CS is adjusted via adjustment of the noise detection signal DS. As the filter unit, an input filter circuit for adjusting the attenuation characteristic of the noise filter 10, e.g., reducing the gain for a specific band, may be used, and for example, an analog filter such as a high-pass filter, a low-pass filter, or a notch filter formed by a resistor and a capacitor, may be used.

The noise filter 10 has the ground capacitor 15 connected between the electric path 11 and the ground line 3. The noise detection unit 12, the injection unit 14, and the ground capacitor 15 form a main circuit part 101 of the noise filter 10. The control characteristic of the noise filter 10 greatly depends on the main circuit part 101. The inductance value of the main circuit part 101 is the sum of the inductance value of a common mode transformer forming the noise detection unit 12 and the inductance value of a common mode transformer forming the injection unit 14. The capacitance value of the main circuit part 101 is the capacitance value of the ground capacitor 15. The details of the control characteristic of the main circuit part 101 will be described later.

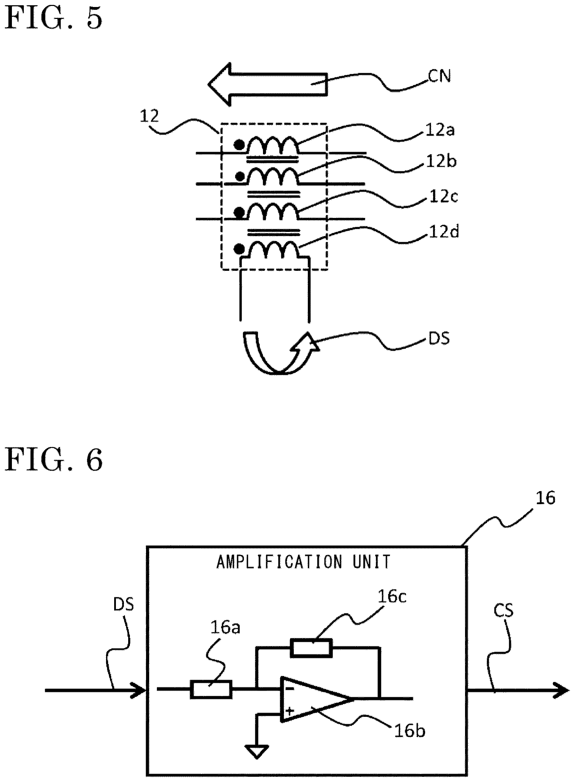

FIG. 5 is a configuration diagram showing the noise detection unit according to Embodiment 1. The noise detection unit 12 is formed by a common mode transformer. Here, the common mode transformer forming the noise detection unit 12 is referred to as a detection transformer. The detection transformer includes, on the electric path 11 connected to the power supply line 2 (not shown) of the AC power supply 1, an R-phase winding 12a wound around an R-phase power line, an S-phase winding 12b wound around an S-phase power line, a T-phase winding 12c wound around a T-phase power line, and an auxiliary winding 12d. The R-phase winding 12a, the S-phase winding 12b, and the T-phase winding 12c are wound in the same phase. In the noise detection unit 12 configured as described above, magnetic fluxes generated in a normal mode are canceled out and magnetic fluxes generated in a common mode intensify each other.

The detection transformer configured as described above has a high inductance value only for a common mode noise, and thus works as a common mode choke coil. Then, in the noise detection unit 12, the noise detection signal DS is generated between both ends of the auxiliary winding 12d, due to the common mode noise CN passing through the detection transformer. Both ends of the auxiliary winding 12d are connected to the amplification unit 16, and the noise detection signal DS is sent to the amplification unit 16.

FIG. 6 is a configuration diagram showing an example of the amplification unit according to Embodiment 1. The amplification unit 16 includes an input resistor 16a, an operational amplifier 16b, and a feedback resistor 16c. An inverting input terminal of the operational amplifier 16b is connected to the input terminal side (left side in FIG. 6) of the amplification unit 16 via an input resistor 16a, and the inverting input terminal of the operational amplifier 16b is also connected to an output terminal of the operational amplifier 16b via the feedback resistor 16c.

A non-inverting input terminal of the operational amplifier 16b is grounded. The amplification unit 16 shown in FIG. 6 is an inverting amplifier circuit using the operational amplifier 16b, but may be a non-inverting amplifier circuit. The amplification unit 16 amplifies the noise detection signal DS at an amplification factor which is given by the ratio between the resistance value of the input resistor 16a and the resistance value of the feedback resistor 16c, to generate the cancellation signal CS, and outputs the cancellation signal CS.

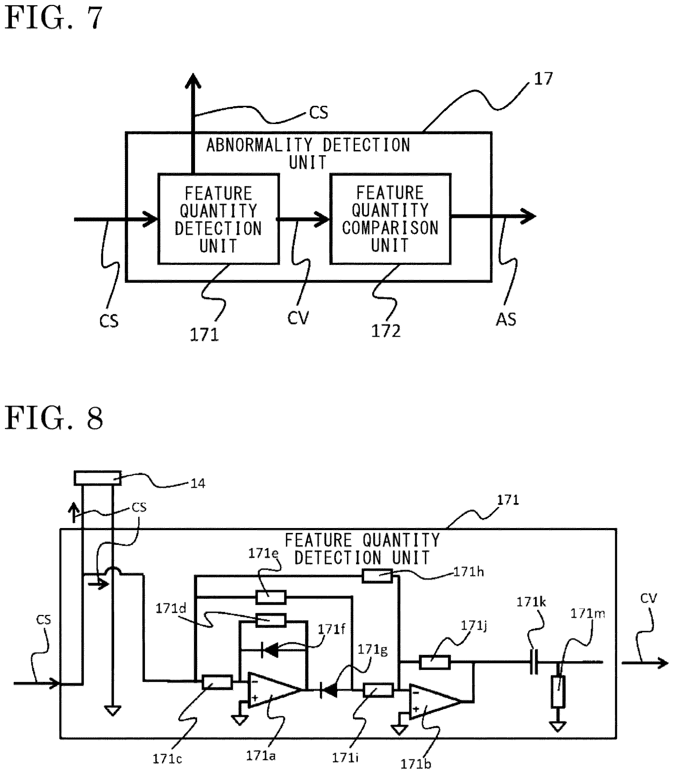

FIG. 7 is a configuration diagram showing an example of the abnormality detection unit according to Embodiment 1. The abnormality detection unit 17 includes a feature quantity detection unit 171 (corresponding to a feature quantity acquisition unit) which outputs a feature quantity signal CV for detecting abnormality using output voltage of the cancellation signal CS, and a feature quantity comparison unit 172 (corresponding to an abnormality determination unit) which generates an abnormality detection signal AS by performing predetermined calculation on the feature quantity signal CV, and outputs the abnormality detection signal AS. Here, in a case where abnormality of the noise filter 10 is detected, the abnormality detection signal AS is outputted as ON, and in a case where abnormality is not detected, the abnormality detection signal AS is outputted as OFF.

FIG. 8 is a configuration diagram showing an example of the feature quantity detection unit according to Embodiment 1. The feature quantity detection unit 171 generates the feature quantity signal CV on the basis of the voltage value of output voltage of the cancellation signal CS, and outputs the feature quantity signal CV. The feature quantity signal CV is a signal representing a feature quantity to be used for abnormality detection.

For a value to be used as the feature quantity, various values are conceivable. In the example shown in FIG. 8, the feature quantity detection unit 171 has a configuration for a case of using a voltage average value of output voltage of the cancellation signal CS as the feature quantity. As shown in FIG. 8, the feature quantity detection unit 171 is configured such that a low-pass filter formed by a capacitor 171k and a resistor 171m is connected to an output side of an absolute value detection circuit formed by operational amplifiers 171a, 171b, resistors 171c to 171e, diodes 171f, 171g, and resistors 171h to 171j.

The feature quantity detection unit 171 has an input terminal (not shown) connected to an output terminal of the amplification unit 16, and output voltage of the cancellation signal CS is inputted as an input signal to the feature quantity detection unit 171. As shown in FIG. 8, the above input signal (cancellation signal CS) inputted to the feature quantity detection unit 171 is sent to the injection unit 14 and also is inputted to the absolute value detection circuit. When the cancellation signal CS is inputted to the absolute value detection circuit, an absolute value of the voltage value of output voltage of the cancellation signal CS is outputted from the absolute value detection circuit.

Since the output of the absolute value detection circuit is averaged by the low-pass filter, a voltage average value of output voltage of the cancellation signal CS is outputted from the low-pass filter. That is, the output of the feature quantity detection unit 171 indicates the voltage average value of output voltage of the cancellation signal CS. The output of the feature quantity detection unit 171 is sent as the feature quantity signal CV to the feature quantity comparison unit 172. The circuit of the feature quantity detection unit 171 is not limited to the example shown in FIG. 8, and may be freely configured without deviating from the scope of the present invention.

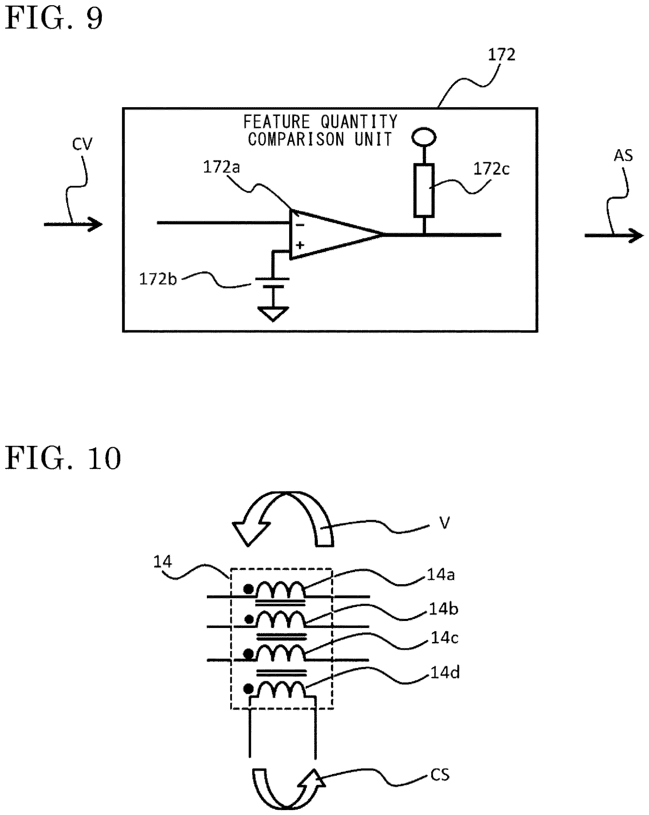

FIG. 9 is a configuration diagram showing an example of the feature quantity comparison unit according to Embodiment 1. The feature quantity comparison unit 172 generates the abnormality detection signal AS by performing predetermined calculation on the feature quantity signal CV outputted from the feature quantity detection unit 171, and outputs the generated abnormality detection signal AS. In this example, the feature quantity comparison unit 172 is configured as a comparator circuit that compares the feature quantity signal CV with a predetermined threshold. The feature quantity comparison unit 172 includes a comparator 172a, a DC voltage source 172b, and a pull-up resistor 172c.

An inverting input terminal of the comparator 172a is connected to the input terminal side (left side in FIG. 9) of the feature quantity comparison unit 172, and a non-inverting input terminal of the comparator 172a is connected to a positive electrode of the DC voltage source 172b. A negative electrode of the DC voltage source 172b is grounded. An output terminal of the comparator 172a is connected to the output terminal side (left side in FIG. 9) of the feature quantity comparison unit 172, and the pull-up resistor 172c is connected between the output terminal of the comparator 172a and the output terminal of the feature quantity comparison unit 172.

When the feature quantity signal CV is inputted as an input signal to the feature quantity comparison unit 172, the magnitude of the feature quantity signal CV and the magnitude of the voltage of the DC voltage source 172b are compared with each other, and the abnormality detection signal AS is outputted in accordance with a result of comparison. Specifically, for example, in a case where the feature quantity signal CV is greater than the voltage of the DC voltage source 172b, abnormality is detected and thus the abnormality detection signal AS is outputted as ON. In this case, the voltage value of the DC voltage source 172b serves as a threshold for determination as to whether or not there is abnormality. The circuit of the feature quantity comparison unit 172 is not limited to the example shown in FIG. 9, and may be freely configured without deviating from the scope of the present invention.

FIG. 10 is a configuration diagram showing the injection unit according to Embodiment 1. The injection unit 14 is formed by a common mode transformer. Here, the common mode transformer forming the injection unit 14 is referred to as an injection transformer. The injection transformer includes, on the electric path 11, an R-phase winding 14a wound around the R-phase power line, an S-phase winding 14b wound around the S-phase power line, a T-phase winding 14c wound around the T-phase power line, and an auxiliary winding 14d. The R-phase winding 14a, the S-phase winding 14b, and the T-phase winding 14c are wound in the same phase.

The injection transformer configured as described above has a high inductance value only for a common mode, and thus works as a common mode choke coil. In the injection unit 14 formed by the injection transformer as described above, when the cancellation signal CS is inputted between both ends of the auxiliary winding 14d, the cancellation signal CS inputted to the auxiliary winding 14d induces voltage V for canceling the common mode noise CN, on the R-phase winding 14a, the S-phase winding 14b, and the T-phase winding 14c.

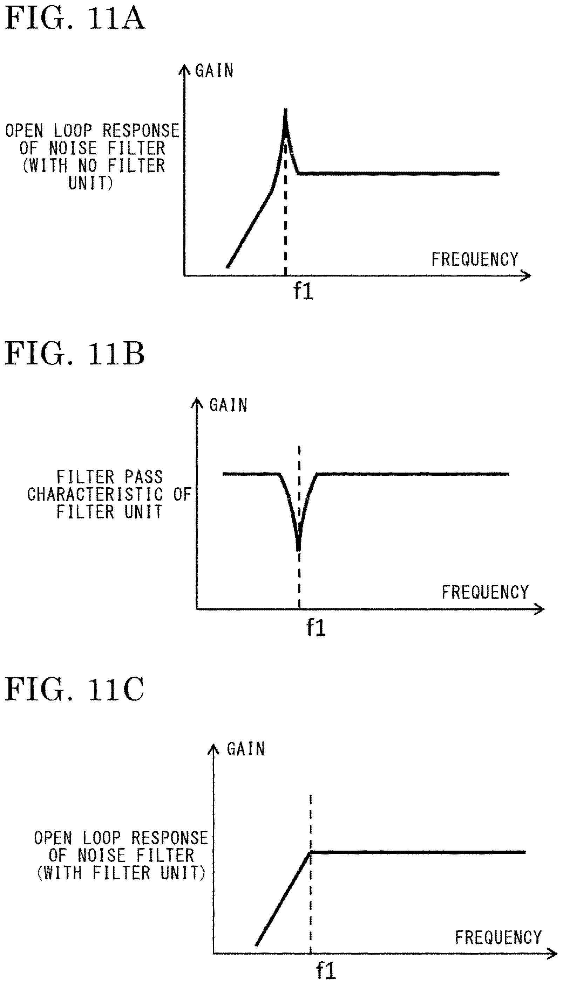

Here, control response of the main circuit part 101 of the noise filter 10 will be described. FIG. 11A to FIG. 11C are schematic graphs showing control response of the main circuit part of the noise filter in Embodiment 1. FIG. 11 Ais a schematic graph showing control response in a case of having no filter unit, FIG. 11B is a schematic graph showing the pass characteristic of the filter unit, and FIG. 11C is a schematic graph showing control response in a case of having the filter unit. In FIG. 11A to FIG. 11C, the horizontal axis indicates the frequency and the vertical axis indicates the gain. Here, the control response refers to open loop response on a path starting from an output of the noise detection unit 12, passing through the cancellation signal output unit 13 and the injection unit 14, and then returning to the noise detection unit 12.

Control stability of the noise filter 10 depends on the values of a gain margin and a phase margin of the open loop response. In addition, the "filter unit" is a filter unit for adjusting the characteristic of the cancellation signal CS as described above, and the "filter unit" in FIG. 11A to FIG. 11C refers to the filter unit provided between the noise detection unit 12 and the amplification unit 16. As described above, the filter unit adjusts the characteristic of the cancellation signal CS through adjustment of the noise detection signal DS.

As shown in FIG. 11A, in open loop response in the case of having no filter unit, a great resonance peak arises and the gain sharply increases, at a resonant frequency f1 of the main circuit part 101. In addition, phase rotation occurs at the resonant frequency f1, although not shown in the graph. Thus, in the case of having no filter unit, control response becomes unstable at the resonant frequency f1.

In a case where a component at the resonant frequency f1 is contained in the common mode noise CN detected by the noise detection unit 12, there is a possibility that the cancellation signal CS also becomes unstable. The resonant frequency f1 is represented as f1 = 1/{2π√(L1×C1)}. Here, L1 is the inductance value of the main circuit part 101, and C1 is the capacitance value of the main circuit part 101.

As described above, in the case of having no filter unit, control response becomes unstable at the resonant frequency f1, and therefore the filter unit having the filter pass characteristic shown in FIG. 11B is provided between the noise detection unit 12 and the amplification unit 16. This filter unit is configured such that the rejection frequency thereof coincides with the resonant frequency f1 of the main circuit part 101. Such a filter unit can be realized by a notch filter. By configuring the filter unit as described above, a filter pass characteristic in which the gain is greatly reduced at the resonant frequency f1 is obtained as shown in FIG. 11B.

Thus, in open loop response in the case of having the filter unit, as shown in FIG. 11C, the great resonance peak at the resonant frequency f1 is attenuated by the filter pass characteristic of the filter unit.

As described above, in the case of providing the filter unit between the noise detection unit 12 and the amplification unit 16, it is possible to generate the cancellation signal CS with the resonance peak attenuated, even if a component at the resonant frequency f1 is contained in the common mode noise CN detected by the noise detection unit 12. As a result, the noise filter 10 can exert a noise suppression effect stably.

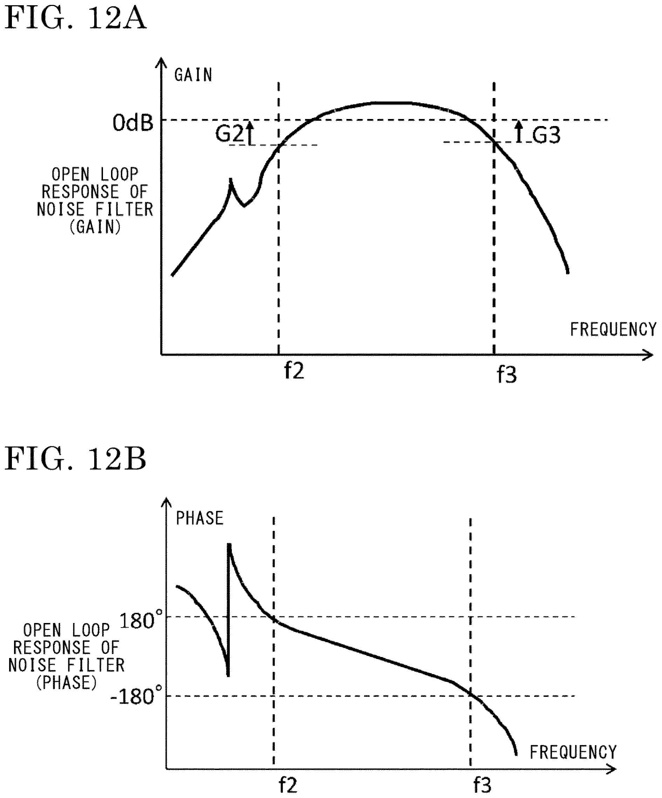

FIG. 12A and FIG. 12B are schematic graphs showing control response of the noise filter in Embodiment 1. FIG. 12A is a schematic graph showing the gain characteristic, and FIG. 12B is a schematic graph showing the phase characteristic. In the characteristic (control characteristic) of control response of the noise filter 10, the phase rotates due to phase lags in the main circuit part 101, the amplification unit 16, and the filter unit.

In the examples shown in FIG. 12A and FIG. 12B, as the filter unit, a notch filter and a low-pass filter (both are not shown in the drawings) are combined so that the resonance peak at the resonant frequency f1 as described above is suppressed and a gain margin G2 at a phase inversion frequency f2 in a low-frequency band and a gain margin G3 at a phase inversion frequency f3 in a high-frequency band are each set at a value that can ensure control stability. Here, the gain margins G2 and G3 are indicated by upward arrows when they have positive values, and indicated by downward arrows when they have negative values. The value that can ensure control stability is, for example, 6 dB.

Here, regarding the noise filter in which the resonance peak is attenuated and the gain margins G2 and G3 at the phase inversion frequencies are each set at a value that can ensure control stability as in the examples shown in FIG. 12A and FIG. 12B, a situation in which the control characteristic of the noise filter changes due to occurrence of some abnormality will be described.

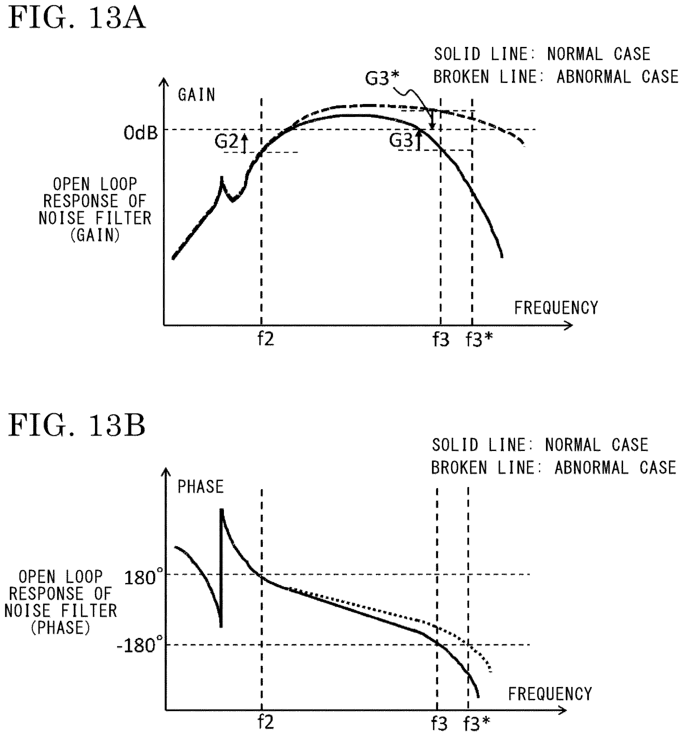

FIG. 13A and FIG. 13B are schematic graphs showing control response of the noise filter in Embodiment 1. FIG. 13A is a schematic graph showing change in the gain characteristic, and FIG. 13B is a schematic graph showing change in the phase characteristic. FIG. 13A and FIG. 13B show a case where the control characteristic has undergone change due to occurrence of abnormality. For comparison between a normal case and an abnormal case, the gain characteristic and the phase characteristic in a normal case are indicated by solid lines, and the gain characteristic and the phase characteristic in an abnormal case are indicated by broken lines.

Here, as "abnormality", it is assumed that the phase inversion frequency f3 in the high-frequency band has changed to a frequency f3*. Atypical example of such abnormality is a case where the function of the low-pass filter is lost due to component failure or the like and the characteristic of the filter unit has changed accordingly. In such a case, the value of the gain margin G3 at the phase inversion frequency f3 in the high-frequency band might change so as to deviate from the value that can ensure control stability.

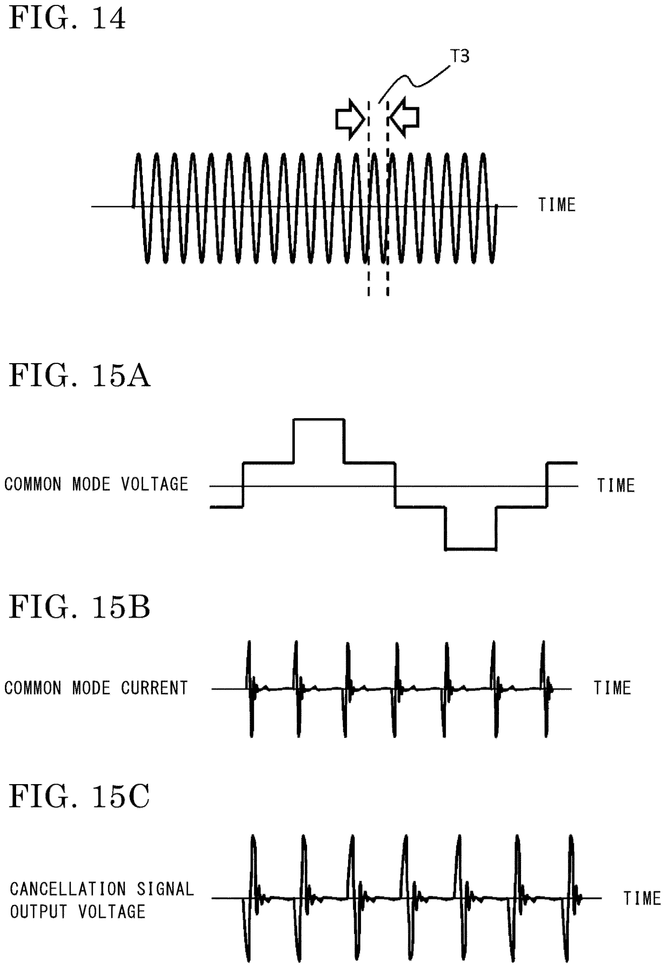

As shown in FIG. 13A, the gain margin at the phase inversion frequency f3 in the high-frequency band has changed to a gain margin G3* having a negative value. Thus, it is found that control response of the noise filter 10 has become unstable. In this case, the cancellation signal CS outputted from the cancellation signal output unit 13 also becomes an unstable signal having an abnormal output waveform, so that the abnormal and unstable cancellation signal CS is injected into the electric path 11. FIG. 14 is a schematic graph showing the abnormal output waveform of the cancellation signal output unit according to Embodiment 1, and shows an example of the waveform of the cancellation signal CS in an abnormal case. In FIG. 14, the horizontal axis indicates time. Since the gain margin at the phase inversion frequency f3 has become a negative value, as shown in FIG. 14, the frequency component at the phase inversion frequency f3 continues to be amplified, thus causing oscillation. A section between broken lines indicated by arrows in FIG. 14 indicates a cycle T3 of the cancellation signal CS in an abnormal case. The cycle T3 is equal to the reciprocal of the phase inversion frequency f3.

When the cancellation signal CS has caused oscillation, a noise source for the common mode noise CN is produced also at the noise filter 10 in the common mode equivalent circuit shown in FIG. 3. In the common mode equivalent circuit, the load 90, a grid, and the power conversion device 80 bear noise source voltage in accordance with their respective impedance ratios. On the grid side, the noise filter 10 does not operate normally and thus a normal attenuation amount is not obtained, and in addition, conduction noise due to oscillation operation of the noise filter 10 flows out to the grid via the electric path 11. On the load 90 side, for example, shaft voltage of a motor might increase. In the power conversion device 80, erroneous operation might be caused by the common mode noise CN generated by itself.

As described above, in a case of using an active noise filter such as the noise filter 10, it is not desirable that abnormal output operation such as control oscillation which can be caused by characteristic change due to component failure or the like is left.

In Embodiment 1, the injection unit 14 is formed by a common mode transformer. The common mode transformer forming the injection unit 14 serves as an inductance load having an inductive impedance for the cancellation signal output unit 13, and thus has a high impedance in a high-frequency band. Therefore, even in a state in which the cancellation signal output unit 13 continues performing abnormal high-frequency oscillation operation as shown in FIG. 14 and the noise filter 10 cannot normally perform noise suppression operation, a phenomenon such as overvoltage or overcurrent that influences the standards of circuit components does not immediately occur in the cancellation signal output unit 13. That is, as long as abnormality of the noise filter 10 cannot be detected, the noise filter 10 is not stopped by a protection function even if an overvoltage protection circuit or an overcurrent protection circuit is provided to the noise filter 10.

Accordingly, in the noise filter 10, abnormality detection is performed by the abnormality detection unit 17, and if abnormality is detected, the protection circuit 18 is operated to stop generation and injection of the cancellation signal CS. Hereinafter, this will be described specifically while comparing the cancellation signal in a normal case and the cancellation signal in an abnormal case.

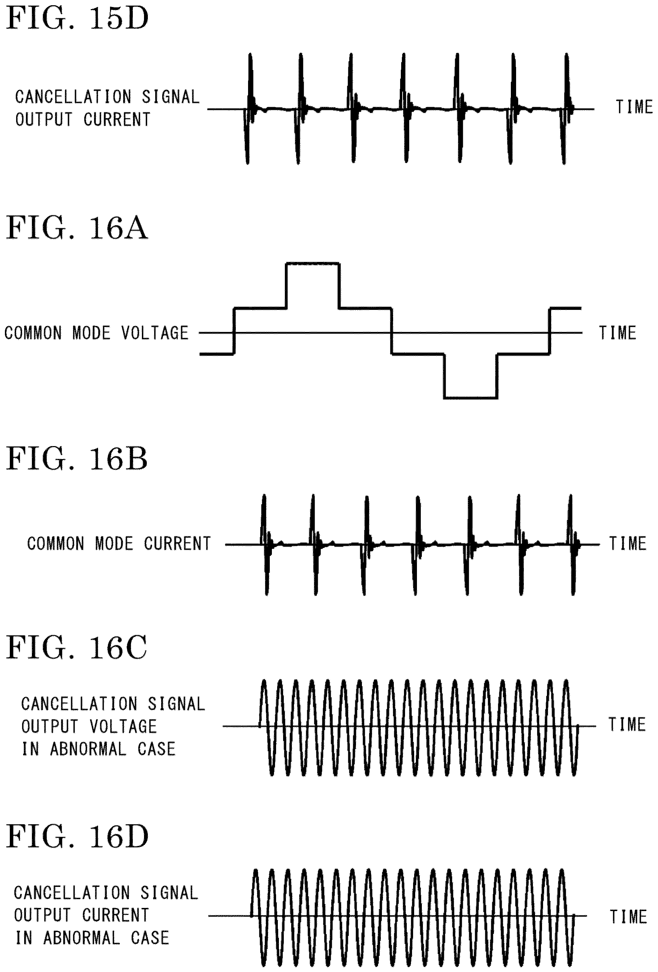

FIG. 15A is a schematic graph showing the waveform of common mode voltage in a normal case, and FIG. 15B is a schematic graph showing the waveform of common mode current. FIG. 15C is a schematic graph showing the waveform of output voltage of the cancellation signal according to Embodiment 1 in a normal case, and FIG. 15D is a schematic graph showing the waveform of output current of the cancellation signal. In FIG. 15A to FIG. 15D, the horizontal axis indicates time. Here, the common mode voltage is voltage of the common mode noise CN. The common mode current is current flowing through the electric path 11 due to the common mode voltage, and is current flowing through the electric path 11 when the common mode voltage is inputted to the common mode equivalent circuit shown in FIG. 3 and under the assumption that the noise filter 10 is absent. The common mode voltage arises due to switching operation of each semiconductor switch of the power conversion device 80 shown in FIG. 2 and has a rectangular waveform as shown in FIG. 15A. The common mode current has a spike-shaped waveform as shown in FIG. 15B and causes a noise problem at various locations on the path. The noise detection unit 12 of the noise filter 10 detects the common mode current and sends the noise detection signal DS to the cancellation signal output unit 13, and the cancellation signal output unit 13 generates the cancellation signal CS from the noise detection signal DS. The cancellation signal CS is injected into the electric path 11 via the injection unit 14.

Output voltage of the cancellation signal CS in a normal case has a spike-shaped waveform as shown in FIG. 15C. In addition, output current of the cancellation signal CS produced by the output voltage of the cancellation signal CS also has a spike-shaped waveform as shown in FIG. 15D. The output current of the cancellation signal CS is current that cancels out the common mode current, and therefore has a feature that the output current has a waveform in which the average value and the effective value are extremely smaller than the peak value as in the common mode current.

In actuality, noise current flowing out from the power conversion device 80 which is a noise source for the common mode noise CN passes through the injection unit 14, so that a disturbance component is superimposed on the output current of the cancellation signal CS, and in addition, a disturbance component is also superimposed on the output voltage of the cancellation signal CS, as a product of an output impedance for the cancellation signal CS and current. However, for facilitating the understanding of the gist, such superimpositions are ignored in FIG. 15C and FIG. 15D.

FIG. 16A is a schematic graph showing the waveform of common mode voltage in an abnormal case, and FIG. 16B is a schematic graph showing the waveform of common mode current. FIG. 16C is a schematic graph showing the waveform of output voltage of the cancellation signal according to Embodiment 1 in an abnormal case, and FIG. 16D is a schematic graph showing the waveform of output current of the cancellation signal. In FIG. 16A to FIG. 16D, the horizontal axis indicates time. As shown in FIG. 16A and FIG. 16B, the common mode voltage and the common mode current do not change even in an abnormal case. Meanwhile, in an abnormal case, the noise filter 10 has undergone change in the control characteristic, so that the cancellation signal CS causes oscillation. Thus, as shown in FIG. 16C and FIG. 16D, the waveforms of output voltage and output current of the cancellation signal CS become abnormal output waveforms as shown in FIG. 14. The abnormal output waveforms do not have such a feature that the waveforms in a normal case have, i.e., a feature that the average value and the effective value are extremely smaller than the peak value.

Specifically, in the waveforms in an abnormal case shown in FIG. 16C and FIG. 16D, the voltage average value of output voltage of the cancellation signal CS becomes 2/π times the voltage peak value, and thus there is not a great difference between the peak value and the average value. In addition, the current average value of output current of the cancellation signal CS becomes 2/π times the current peak value, and thus there is not a great difference between the peak value and the average value. The same applies also in a case where output voltage of the operational amplifier is saturated due to oscillation operation at a high gain and the waveform of output voltage of the cancellation signal CS becomes a rectangular waveform. In an abnormal case, each of the effective values of the output voltage and the output current also becomes 1/√2 times the peak value, and therefore the relationship between the peak value and the effective value is the same as the relationship between the peak value and the average value described above. Then, description will be given focusing on the average value, below.

As described above, in an abnormal case, it is found that the voltage average value of output voltage and the current average value of output current of the cancellation signal CS become greater than in a normal case. That is, in this case, the voltage average value of output voltage of the cancellation signal CS can be used as a determination criterion. In this case, by providing an appropriate threshold and comparing the actual voltage average value with the threshold, it is possible to determine whether the noise filter 10 is normally operating, i.e., the noise filter 10 is successfully canceling out the common mode current, or the noise filter 10 has fallen into abnormal operation for some reason.

Typically, where the voltage average value of output voltage of the cancellation signal CS in a normal case is denoted by V1, the threshold for the voltage average value for determining whether or not there is abnormality is denoted by Vth, and the voltage average value at the time of abnormal operation is denoted by V2, the threshold Vth for the voltage average value may be selected so as to satisfy V1 < Vth < V2, whereby it is possible to determine whether or not there is abnormality. The same applies to a case of using the current average value of output current of the cancellation signal CS for determination as to whether or not there is abnormality.

As described above, the feature quantity detection unit 171 outputs the voltage average value of output voltage of the cancellation signal CS, as the feature quantity signal CV. Further, the DC voltage source 172b of the feature quantity comparison unit 172 provides its output voltage value as a threshold for determination as to whether or not there is abnormality. That is, the output voltage value of the DC voltage source 172b is the threshold Vth for the voltage average value.

Thus, the voltage average value of output voltage of the cancellation signal CS and the threshold Vth of the voltage average value are compared with each other in the feature quantity comparison unit 172. If the voltage average value of output voltage of the cancellation signal CS is greater than the threshold Vth, the output of the comparator 172a becomes HIGH, so that the feature quantity comparison unit 172 outputs the abnormality detection signal AS, as ON. If the voltage average value of output voltage of the cancellation signal CS is not greater than the threshold Vth, the output of the comparator 172a becomes LOW, so that the feature quantity comparison unit 172 outputs the abnormality detection signal AS, as OFF.

In Embodiment 1, the abnormality detection signal AS outputted from the feature quantity comparison unit 172 is inputted to the protection circuit 18. Typically, the protection circuit 18 is formed by a control relay. The protection circuit 18 disconnects the control power supply 19 and the cancellation signal output unit 13 from each other on the basis of the abnormality detection signal AS, to interrupt supply of power from the control power supply 19 to the cancellation signal output unit 13.

Thus, in the cancellation signal output unit 13 for which supply of power is stopped, the cancellation signal CS is no longer generated by the amplification unit 16. In addition, injection of the cancellation signal CS into the electric path 11 is also no longer performed, so that the cancellation signal CS having an abnormal output waveform is prevented from being injected into the electric path 11.

After abnormality is detected by the abnormality detection unit 17 and interruption operation by the protection circuit 18 is executed, for example, when the abnormality detection signal AS is outputted as OFF from the feature quantity comparison unit 172, interruption operation of the protection circuit 18 may be reset, so that generation and injection of the cancellation signal CS are restored. Regarding abnormality that has been known to be a temporary one in advance, restoration may be performed after elapse of a predetermined time, by using a delay circuit or a counter circuit.

In Embodiment 1, the example in which the amplification unit 16 is configured as a circuit using the operational amplifier 16b, has been shown. However, the amplification unit 16 may be configured as another inverting amplifier circuit or non-inverting amplifier circuit, for example. In addition, the example in which the protection circuit 18 performs interruption operation in accordance with the abnormality detection signal AS, has been shown.

However, for example, interruption operation may be latched or interruption operation may be allowed to be canceled using a combination with a reset circuit, thus making it possible to perform operation other than simple interruption operation, by using a combination with a logic circuit. In addition, the example in which the feature quantity detection unit 171 is configured as a circuit using an operational amplifier 171a, 171b, has been shown.

However, for example, any circuit that can achieve the same purpose may be adopted. The example in which a quantity to be detected by the feature quantity detection unit 171 is a voltage average value, has been shown. However, the feature quantity detection unit 171 may be configured to detect a different value such as an instantaneous value or an effective value, as a feature quantity. In addition, the example in which the feature quantity comparison unit 172 is configured as a circuit using the comparator 172a, has been shown. However, for example, another circuit that can achieve the same purpose may be adopted.

Further, in the noise filter 10 of Embodiment 1, a common mode choke coil other than the noise detection unit 12 and the injection unit 14 may be connected on the electric path 11. One or both of the noise detection unit 12 and the injection unit 14 may be formed by a capacitor instead of a common mode transformer. In a case of forming the injection unit 14 by a capacitor, a pulse transformer may be interposed between the injection unit 14 and the cancellation signal output unit 13.

In Embodiment 1, in a case where the injection unit 14 is formed by a capacitor instead of a common mode transformer and a pulse transformer is not interposed between the capacitor and the cancellation signal output unit 13, the impedance of the injection unit 14 becomes capacitive for the cancellation signal output unit 13. In this case, a frequency band for which it is difficult to detect abnormality without the abnormality detection unit 17 is a low-frequency band.

On the other hand, in a case where the injection unit 14 is formed by a capacitor instead of a common mode transformer and a pulse transformer is interposed between the capacitor and the cancellation signal output unit 13, the impedance of the injection unit 14 becomes inductive for the cancellation signal output unit 13, and a frequency band for which it is difficult to detect abnormality without the abnormality detection unit 17 is a high-frequency band as in a case where the injection unit 14 is formed by a common mode transformer. The noise filter 10 according to Embodiment 1 can perform abnormality detection more assuredly by the abnormality detection unit 17, irrespective of whether the injection unit 14 is inductive or capacitive.

In Embodiment 1, as one example of the power supply interruption means, the protection circuit 18 is used. However, as another example of the power supply interruption means, a control circuit for stopping the control power supply 19 on the basis of the abnormality detection signal AS may be used.

According to Embodiment 1, it is possible to achieve high reliability. More specifically, the noise filter includes an abnormality detection unit which detects abnormality of the noise filter on the basis of output voltage of a cancellation signal and outputs an abnormality detection signal, and a protection circuit which interrupts supply of power to the cancellation signal output unit on the basis of the abnormality detection signal.

With this configuration, in a case where abnormality has occurred due to change in the control characteristic of the noise filter, the abnormality is detected from change in output voltage of the cancellation signal due to the abnormality, and supply of power to the cancellation signal output unit is stopped, whereby an abnormal cancellation signal can be prevented from being injected into the electric path, thus ensuring high reliability. In particular, high reliability is ensured with respect to change in the control characteristic of the noise filter itself.

In addition, since abnormality of the noise filter is detected on the basis of output voltage of the cancellation signal, it is possible to assuredly detect abnormality of the noise filter in a high-frequency band even if the injection unit for the cancellation signal is formed by an inductance load such as a common mode transformer, and it is possible to assuredly detect abnormality of the noise filter in a low-frequency band even if the injection unit is formed by a capacitive load such as a capacitor.

In addition, since generation and injection of the cancellation signal are stopped by the protection circuit when abnormality is detected, stable operation can be performed while the gain margin and the phase margin for suppressing control oscillation can be set at lower values than in conventional art. That the gain margin and the phase margin can be set at lower values than in conventional art means that the control gain of the noise filter is improved, and thus the noise suppression amount can be improved.

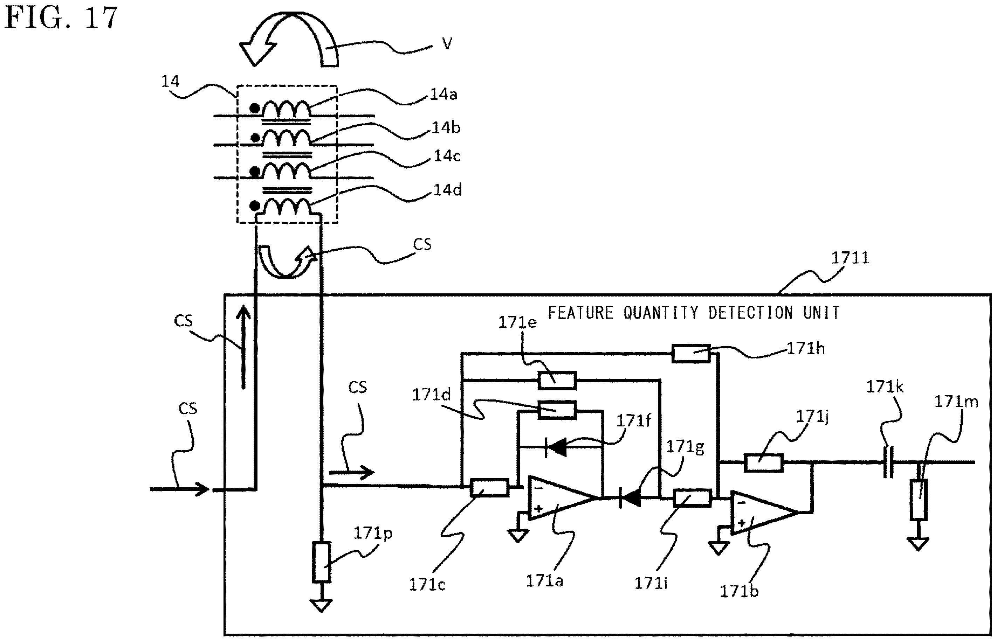

Next, a feature quantity detection unit according to another example of Embodiment 1 will be described with reference to FIG. 17. Parts that are the same as or correspond to those in FIG. 1 to FIG. 16D are denoted by the same reference characters, and the description thereof is omitted. FIG. 17 is a configuration diagram showing the feature quantity detection unit according to the other example of Embodiment 1. In this example, in a feature quantity detection unit 1711, the current average value of output current of the cancellation signal CS is detected as a feature quantity.

As in the feature quantity detection unit 171 of Embodiment 1, the absolute value detection circuit is provided inside the feature quantity detection unit 1711. Meanwhile, in the feature quantity detection unit 1711, a current detection resistor 171p, e.g., a shunt resistor, is provided between the injection unit 14 and a control ground, and the input side of the absolute value detection circuit of the feature quantity detection unit 1711 is connected to an electric path connecting the injection unit 14 and a terminal on the injection unit 14 side of the current detection resistor 171p. Thus, an input signal to the absolute value detection circuit in the feature quantity detection unit 1711 is output current of the cancellation signal CS. Since the output current of the cancellation signal CS is the input signal as described above, the feature quantity signal CV is the current average value of the cancellation signal CS. The other matters are the same as those in Embodiment 1 and therefore the description thereof is omitted. Also in this example, the same effects as in Embodiment 1 can be obtained.

### Embodiment 2

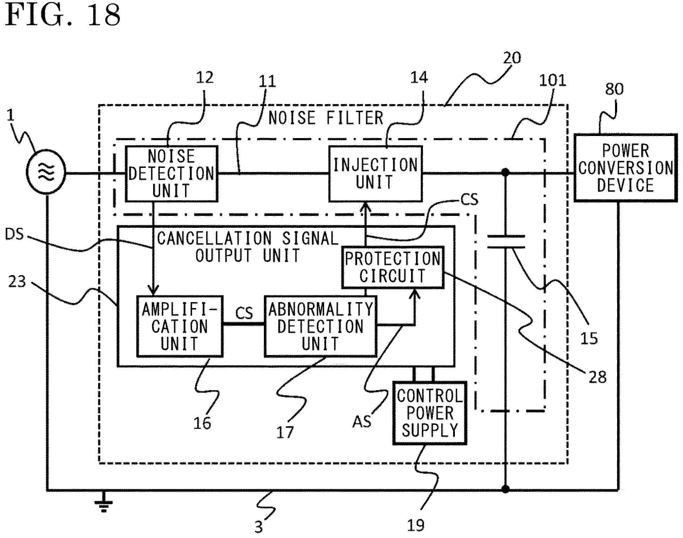

Next, Embodiment 2 will be described with reference to FIG. 18. Parts that are the same as or correspond to those in FIG. 1 to FIG. 17 are denoted by the same reference characters, and the description thereof is omitted. FIG. 18 is a configuration diagram of the noise filter in Embodiment 2. A noise filter 20 has a protection circuit 28 interposed between the abnormality detection unit 17 and the injection unit 14 in a cancellation signal output unit 23. On the other hand, the protection circuit 18 interposed between the control power supply 19 and the cancellation signal output unit 13 in the noise filter 10 of Embodiment 1 is not provided.

The abnormality detection unit 17 outputs the abnormality detection signal AS to the protection circuit 28. In the noise filter 20, the cancellation signal CS outputted from the amplification unit 16 is sent through the abnormality detection unit 17 and the protection circuit 18 to the injection unit 14. In Embodiment 2, as protection means for inhibiting an abnormal cancellation signal CS from being injected into the electric path 11, injection blocking means for interrupting transmission of the cancellation signal CS from the amplification unit 16 of the cancellation signal output unit 23 to the injection unit 14 is provided. In addition, in Embodiment 2, the protection circuit 28 is provided as one example of the injection blocking means.

The protection circuit 28 interrupts a path for the cancellation signal CS between the abnormality detection unit 17 and the injection unit 14, on the basis of the abnormality detection signal AS. Thus, in a case where abnormality is detected in the abnormality detection unit 17, an abnormal cancellation signal CS is prevented from being sent to the injection unit 14, whereby the abnormal cancellation signal CS is prevented from being injected into the electric path 11. The configuration of the protection circuit 28 may be the same as that of the protection circuit 18 in Embodiment 1. Embodiment 2 and Embodiment 1 may be combined so that the protection circuit 18 and the protection circuit 28 are both provided. In this case, even if one of the protection circuits has lost its interruption function due to failure or the like, the interruption function of the other protection circuit can prevent an abnormal cancellation signal CS from being injected into the electric path 11.

The other matters are the same as those in Embodiment 1 and therefore the description thereof is omitted.

According to Embodiment 2, the same effects as in Embodiment 1 can be obtained.

### Embodiment 3

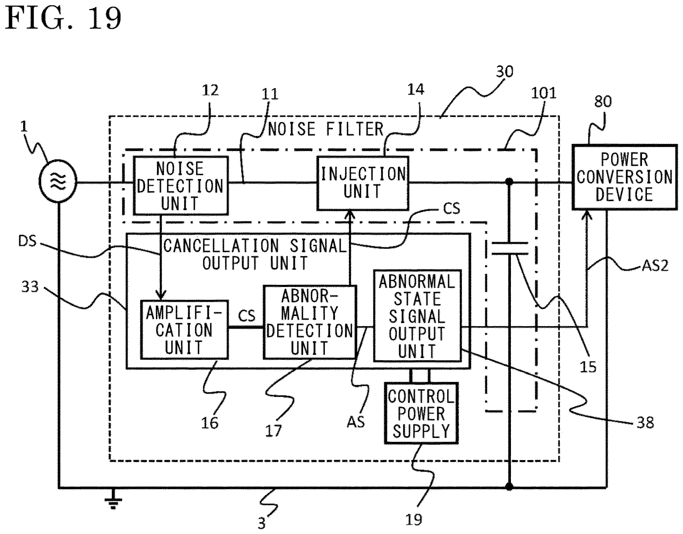

Next, Embodiment 3 will be described with reference to FIG. 19. Parts that are the same as or correspond to those in FIG. 1 to FIG. 18 are denoted by the same reference characters and the description thereof is omitted. FIG. 19 is a configuration diagram of a noise filter according to Embodiment 3. The noise filters of embodiments 1 and 2 each have the protection circuit for performing interruption operation on the basis of the abnormality detection signal AS. In Embodiment 3, instead of using such a protection circuit, abnormality of the noise filter is reported to the noise source. A noise filter 30 has an abnormal state signal output unit 38 in a cancellation signal output unit 33, and the abnormality detection signal AS outputted from the abnormality detection unit 17 is inputted to the abnormal state signal output unit 38. In Embodiment 3, as protection means for inhibiting an abnormal cancellation signal CS from being injected into the electric path 11, the abnormal state signal output unit 38 is provided.

The abnormal state signal output unit 38 has an output circuit that can output a signal to the power conversion device 80, and outputs an abnormal state signal AS2 to the power conversion device 80 when the abnormality detection signal AS is inputted. Typically, the abnormal state signal AS2 is a differential signal robust to disturbance, a current signal for a low impedance, or the like, and is generated on the basis of the abnormality detection signal AS. In addition, the abnormal state signal AS2 is isolated from a control potential of the noise filter 30, as necessary.

The power conversion device 80 that has received the abnormal state signal AS2 recognizes that the noise filter 30 is in an abnormal state. The power conversion device 80 that has recognized that the noise filter 30 is in an abnormal state performs processing such as stopping operation, in accordance with the details of the abnormality. A control circuit for stopping the power conversion device 80 on the basis of the abnormal state signal AS2 may be provided outside or inside the power conversion device 80. The control circuit receives the abnormal state signal AS2 and sends a stop instruction to the power conversion device 80 as necessary.

According to Embodiment 3, it is possible to provide the noise filter having high reliability. In Embodiment 3, unlike embodiments 1 and 2, injection of an abnormal cancellation signal into the electric path is not directly prevented by the protection circuit. Instead, by the abnormal state signal, the power conversion device which is a noise source for the common mode noise is made to recognize abnormality of the noise filter. In this case, the power conversion device performs processing such as stopping operation as necessary, and thus it is possible to prevent an abnormal cancellation signal from being generated and injected into the electric path, by stopping the noise source for the common mode noise.

As described above, in Embodiment 3, the power conversion device which is a noise source is made to recognize abnormality of the noise filter, whereby an abnormal cancellation signal is indirectly prevented from being injected into the electric path, thus achieving high reliability. In Embodiment 3, the protection circuit in embodiments 1 and 2 may be used in combination. In Embodiment 3, since the abnormal state signal is outputted to a noise source for a common mode noise, if there is another controlled device that is a noise source for a common mode noise, the abnormal state signal may be outputted also to the other controlled device.

### Embodiment 4

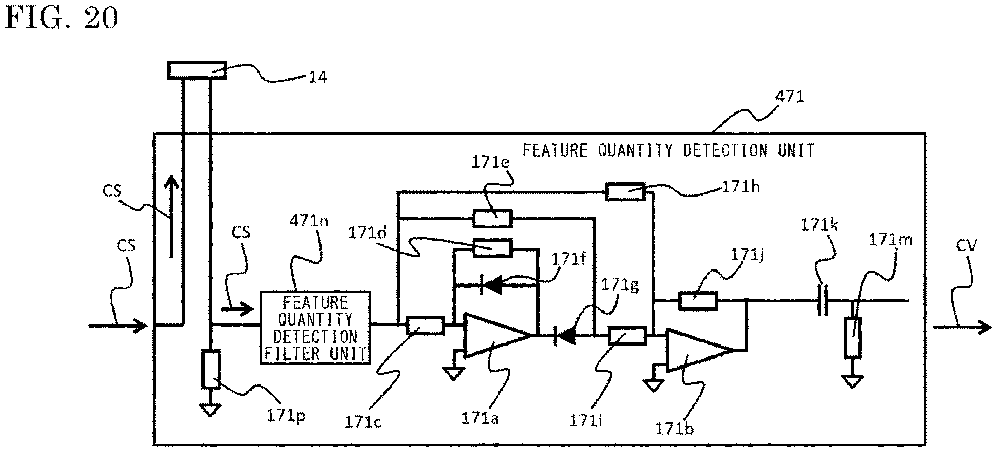

Next, Embodiment 4 will be described with reference to FIG. 20. Parts that are the same as or correspond to those in FIG. 1 to FIG. 19 are denoted by the same reference characters, and the description thereof is omitted. In Embodiment 4, the feature quantity detection unit is different from those in embodiments 1 to 3. FIG. 20 is a configuration diagram of the feature quantity detection unit according to Embodiment 4. A feature quantity detection unit 471 of a noise filter 40 (not shown) is configured such that a feature quantity detection filter unit 471n, i.e., a band limitation filter unit is provided to the feature quantity detection unit 1711 shown in FIG. 17.

More specifically, the current detection resistor 171p is provided between the injection unit 14 and the control ground, and the feature quantity detection filter unit 471n is provided on an electric path connecting the input side of the absolute value detection circuit and the electric path connecting the injection unit 14 and the terminal on the injection unit 14 side of the current detection resistor 171p. An input signal to the feature quantity detection unit 171 is output current of the cancellation signal CS, as in the feature quantity detection unit 1711.

In Embodiment 4, although the configuration in which the feature quantity detection filter unit 471n is provided to the feature quantity detection unit 1711 is adopted, the feature quantity detection filter unit 471n may be provided to the feature quantity detection unit 171 shown in FIG. 8.

The feature quantity detection filter unit 471n performs filtering processing for the input signal to the feature quantity detection unit 471, and is configured to perform weighting in accordance with each frequency component such as a high frequency above a certain frequency. Typically, the feature quantity detection filter unit 471n includes a low-pass filter, a high-pass filter, a notch filter, a band-pass filter, or a filter circuit formed by combination of these filters. Here, the "weighting" includes making a weight for a specific frequency component zero, i.e., removing the specific frequency component. Thus, the feature quantity detection filter unit 471n removes a disturbance component in advance, whereby target abnormality among various abnormalities that can occur in the noise filter 40 can be assuredly detected. Hereinafter, this will be described specifically.

In a case where the control characteristic of the noise filter 40 has undergone change due to occurrence of abnormality, the cancellation signal CS has an abnormal output waveform as shown in FIG. 14 or the like. However, in actuality, noise current flowing out from the power conversion device 80 which is a noise source passes through the injection unit 14, so that a disturbance component is superimposed on the output voltage and the output current of the cancellation signal CS. The disturbance component contains various frequency components.

However, in noise suppression by an active noise filter, it is general that the band for which noise suppression is performed is limited in order to avoid increase in required power of a control circuit for the active noise filter. Typically, a band lower than 150 kHz which is a noise standard target band is not actively taken as a suppression target, and therefore a band around several kHz to several tens of kHz corresponding to a switching carrier frequency of the power conversion device 80 is generally outside the suppression band.

Accordingly, there is a case where noise current of a frequency component around the switching carrier frequency of the power conversion device 80 is not subjected to noise suppression by the active noise filter and is let to flow out to the grid without reduction in the amplitude of the noise current in this band. Meanwhile, when the noise current in the band other than the noise suppression target passes through the injection unit of the active noise filter, disturbance on output voltage and output current of the cancellation signal caused by that noise current sometimes cannot be ignored.

In the case of using the feature quantity detection unit 471, the feature quantity detection filter unit 471n can remove a frequency component around the switching carrier frequency as described above from the input signal (output voltage or output current of the cancellation signal CS) to the feature quantity detection unit 471. Thus, it is possible to, with the influence of disturbance removed, generate the feature quantity signal CV and perform abnormality detection. In this way, according to Embodiment 4, it is possible to assuredly detect target abnormality.

According to Embodiment 4, the same effects as in Embodiment 1 can be obtained.

In addition, since the feature quantity detection filter unit is provided, weighting is performed for the cancellation signal in accordance with respective frequency components, and then a feature quantity is detected, whereby target abnormality can be assuredly detected.

Although the invention is described above in terms of various exemplary embodiments and implementations, it should be understood that the various features, aspects, and functionality described in one or more of the individual embodiments are not limited in their applicability to the particular embodiment with which they are described, but instead can be applied, alone or in various combinations to one or more of the embodiments of the invention.

It is therefore understood that numerous modifications which have not been exemplified can be devised without departing from the scope of the present invention. For example, at least one of the constituent components may be modified, added, or eliminated. At least one of the constituent components mentioned in at least one of the preferred embodiments may be selected and combined with the constituent components mentioned in another preferred embodiment.

For example, the above embodiments according to the present invention have shown the configuration in which the noise filter of the present invention is applied to the power conversion system of a three-phase three-line type, but the noise filter of the present invention may be applied to a power conversion system having a different number of phases and a different number of lines. For example, the noise filter of the present invention may be applied to a power conversion system of a three-phase four-line type or may be applied to a power conversion system of a single-phase two-line type or a single-phase three-line type.

The above Embodiments 1 to 4 have been described basically under the assumption that an analog circuit is used, but may be applied to a digital circuit. In this case, output voltage or output current of the cancellation signal may be subjected to spectrum analysis in the feature quantity detection unit of the abnormality detection unit, and abnormality detection may be performed on the basis of the result of the spectrum analysis.

### DESCRIPTION OF THE REFERENCE CHARACTERS

1 AC power supply
10, 20, 30, 40 noise filter
11 electric path
12 noise detection unit
13, 23, 33 cancellation signal output unit
14 injection unit
16 amplification unit
17 abnormality detection unit
18, 28 protection circuit
19 control power supply
38 abnormal state signal output unit
80 power conversion device
90 load
101 main circuit part
171, 1711, 471 feature quantity detection unit
172 feature quantity comparison unit
AS abnormality detection signal
AS2 abnormal state signal
CN common mode noise
CS cancellation signal
CV feature quantity signal

## Claims

1. A noise filter provided on an electric path connecting an AC power supply, a load which receives supply of power from the AC power supply, and a power conversion device which converts AC power outputted from the AC power supply and outputs the converted AC power to the load, the noise filter comprising:
a noise detection unit which detects a common mode noise flowing through the electric path;
a cancellation signal generation unit which, on the basis of the common mode noise detected by the noise detection unit, generates a cancellation signal for canceling out the common mode noise;
an injection unit which injects the cancellation signal into the electric path;
an abnormality detection unit which detects abnormality of the noise filter on the basis of output voltage or output current of the cancellation signal, and outputs an abnormality detection signal; and
protection means which inhibits the cancellation signal that is abnormal from being injected into the electric path, on the basis of the abnormality detection signal.

2. The noise filter according to claim 1, wherein
the protection means includes power supply interruption means which interrupts supply of power to the cancellation signal generation unit.

3. The noise filter according to claim 2, wherein
the power supply interruption means includes a protection circuit which disconnects connection between the cancellation signal generation unit and a control power supply which supplies power to the cancellation signal generation unit.

4. The noise filter according to any one of claims 1 to 3, wherein
the protection means includes injection blocking means which interrupts transmission of the cancellation signal from the cancellation signal generation unit to the injection unit.

5. The noise filter according to claim 4, wherein
the injection blocking means includes a second protection circuit which disconnects connection between the cancellation signal generation unit and the injection unit.

6. The noise filter according to any one of claims 1 to 5, wherein
the protection means includes an abnormal state signal output unit which generates an abnormal state signal indicating that abnormality has occurred in the noise filter, on the basis of the abnormality detection signal, and outputs the abnormal state signal to a controlled device that serves as a noise source for the common mode noise.

7. The noise filter according to any one of claims 1 to 6, wherein
the abnormality detection unit includes a feature quantity acquisition unit which acquires a feature quantity based on the output voltage or the output current of the cancellation signal, and an abnormality determination unit which performs a determination whether or not there is abnormality, on the basis of a magnitude of the feature quantity, and outputs the abnormality detection signal on the basis of a result of the determination.

8. The noise filter according to claim 7, wherein
the feature quantity acquisition unit includes a band limitation filter unit which performs weighting for respective frequency components contained in the cancellation signal, in accordance with the respective frequency components, and the feature quantity acquisition unit detects the feature quantity on the basis of the output voltage or the output current of the cancellation signal for which the weighting has been performed.

9. The noise filter according to claim 7 or 8, wherein
the feature quantity is an effective value, an average value, or an instantaneous value of the output voltage or the output current of the cancellation signal.
